# EUROPEAN PATENT APPLICATION

(11) **EP 1 024 590 A1**
(43) Date of publication of application: **02.08.2000**
(21) Application number: 99300662.6
(22) Date of filing: 29.01.1999
(51) Int. Cl.: H03D 7/14

(54) **Frequency translation circuitry**

(71) Applicant: LUCENT TECHNOLOGIES INC., Murray Hill, New Jersey 07974-0636 (US)
(72) Inventor: Nader, Rohani, Camberley, Surrey GU15 4RQ (GB)
(74) Representative: Williams, David John

(57) **Abstract**

There is disclosed frequency translation circuitry. The circuitry includes an amplifier connected to receive as an input a single-ended signal and for generating a single-ended amplified signal. The circuitry also includes a matching circuit having an input connected to receive the single-ended amplified signal and for generating a differential signal on first and second outputs. A mixer is connected to receive the differential signal at a first differential input port and a further differential signal at a second input port, and generates a signal having a translated frequency at an output port. Preferably the single-ended signal is an RF signal and the further differential signal is a reference signal from a local oscillator, the translated frequency at the output port being a down-converted frequency. A method of performing such frequency translation is also proposed.

## Description

### Field of the Invention

The present invention relates to frequency translation circuitry in RF receivers, and particularly but not exclusively to down converters in direct conversion (homodyne) receivers.

### Background to the Invention

The double balanced mixer is a commonly used circuit block performing the function of frequency translation in radio frequency (RF) integrated circuits. With the advent of new standards of mobile communications the performance requirements for this block are increasing. In RF receivers the quality of the receiver is generally improved by translating the single-ended RF received signal to a differential signal as early as possible prior to the double-balanced mixer.

In a typical standard receiver the received RF input signal is amplified prior to being provided to the mixer for down-conversion. A matching circuit must be provided to match the output impedance of the amplifier to the input impedance of the mixer.

In a super-heterodyne receiver the amplified signal must also be fed through a SAW (surface acoustic wave) filter prior to mixing. Typically, the amplifier and SAW are provided on a separate chip to the mixer. Thus the matching network must match the output impedance of the SAW filter to the input impedance of the mixer, off-chip.

In a direct conversion receiver a SAW filter is unnecessary, and the matching circuit must match the output of the amplifier to the input of the mixer.

In conventional circuits the matching circuit provides a single-ended output to the mixer. Alternatively, the amplification stage may be a differential amplifier stage, with two matching networks being provided to match the differential outputs of the amplifier to the differential inputs of the mixer. However, because the drive to the amplifier is single ended, a differential output amplifier introduces a loss in performance compared to a single-ended output amplifier. However, use of a single ended amplifier requires a single ended matching circuit to the differential mixer, which introduces a loss in performance compared to a differential matching circuit.

There are three major performance characteristics in all RF circuits, including the mixers. These are: the IIP3; the noise figure (NF); and the gain. The IIP3 is a measure of system linearity, in particular in the presence of strong interference, and is measured in dB. The noise figure is a measure of the intrinsic noise performance of the circuit, and is measured in dB. The gain is a measure of the amplification efficiency of the device, and is measured in dB.

It is an object of the present invention to provide a down converter circuit for use in an RF receiver in which the performance characteristics are improved.

### Summary of the Invention

According to the invention there is provided frequency translation circuitry comprising: an amplifier connected to receive as an input a single-ended signal and for generating a single-ended amplified signal; a matching circuit having an input connected to receive the single-ended amplified signal and for generating a differential signal on first and second outputs; and a mixer connected to receive the differential signal at a first differential input port and a further differential signal at a second input port, and for generating a signal having a translated frequency at an output port.

The matched circuit may comprise a first inductor between the input and the first output, a first capacitor between the first output and ground, a second capacitor between the input and the second output and an inductor between the second output and ground.

The single-ended frequency signal may be an RF signal and the further differential signal a reference signal from a local oscillator, the translated frequency at the output port being a down-converted frequency. Thus there is provided a circuit which improves the gain and noise figure of the receiver in an RF system, and:
- amplifies the input signal;
- converts a single ended RF signal into a balanced signal for driving into the RF port of a mixer; and
- matches the output of the driver amplifier to the mixer input for optimum power transfer and noise match.

Significantly, the single-ended to balanced signal conversion and the matching can be performed on silicon using integrated components. Thus the need for bulky and expensive devices is eliminated.

The invention also provides a method of translating a frequency comprising: amplifying a single-ended frequency signal to thereby generate a single-ended amplified signal; converting the single-ended amplified signal to first and second differential signals; and multiplying the first and second differential signals by respective further first and second differential signals, thereby generating a translated differential signal.

The single-ended frequency signal may be an RF signal and the further first and second differential signals constitute a reference signal from a local oscillator, the translated frequency at the output port being a down-converted frequency.

### Brief Description of the Drawings

Figure 1 illustrates a block schematic of a down-converter according to the present invention;
Figure 2 illustrates an example implementation of the down-converter of Figure 1; and
Figure 3 illustrates an alternative use of the down converter of Figure 1.

### Description of Preferred Embodiment

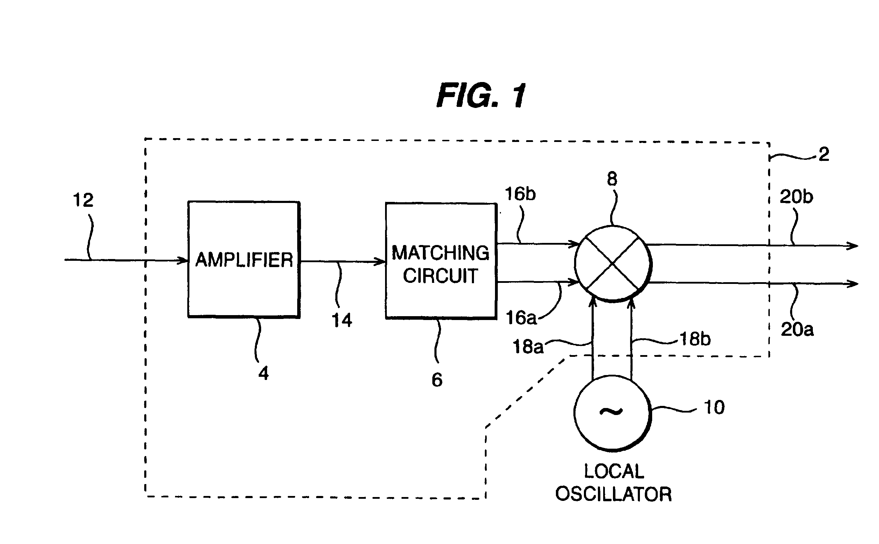

Referring to Figure 1, there is shown a block diagram of a down-converter of an RF receiver according to the present invention. For the purpose of the following description with reference to Figure 1 it is assumed that the RF receiver is a direct-conversion (homodyne) receiver. However, as will be discussed further hereinafter, the frequency translation technique provided by the present invention is more generally applicable.

The down-converter 2 according to the present invention comprises an amplifier 4, which is preferably a low-noise amplifier, a matching circuit 6, and a mixer or multiplier 8. A local oscillator 10 provides a reference signal to the down-converter 2 as discussed further hereinbelow.

The amplifier 4 receives a single ended RF input signal on a signal line 12 which forms the amplifier input. In this example of a direct conversion receiver, the amplifier receives the single ended RF input signal directly from the front end circuitry of the receiver. The amplifier 4 amplifies the single-ended RF input signal on line 12 and generates an amplified single-ended RF signal at its output on line 14.

The matching circuit 6 receives the amplified single-ended RF signal on line 14 and generates, in accordance with the invention, a differential RF signal on a pair of output signal lines 16a and 16b. The local oscillator 10 generates on a pair of signal lines 18a and 18b a differential reference signal. The multiplier 8 receives at a first pair of inputs the differential RF signal on lines 16a and 16b and at a second pair of inputs the differential reference signal on lines 18a and 18b. The mixer 8 multiplies the two differential signals at its inputs and generates a down-converted differential signal at a pair of outputs on a first signal line 20a and a second signal line 20b. The differential output signal on lines 20a and 20b represents the down-converted RF input signal on line 12.

In accordance with the invention, the matching circuit 6 provides two essential functions. Firstly, it must match the output impedance of the amplifier 4 to the input impedance of the mixer 8. Secondly, it must convert the single ended RF amplified signal on line 14 into a differential output signal on the pair of lines 16a and 16b. Thus the matching circuit 6 is additionally a balun. The single-ended to differential conversion provided by the matching circuit means that the matching circuit must not only match the output impedance of the amplifier 4 to the input impedance of mixer 8, but that it must identically match the output impedance of the amplifier 4 to two inputs of the mixer 8.

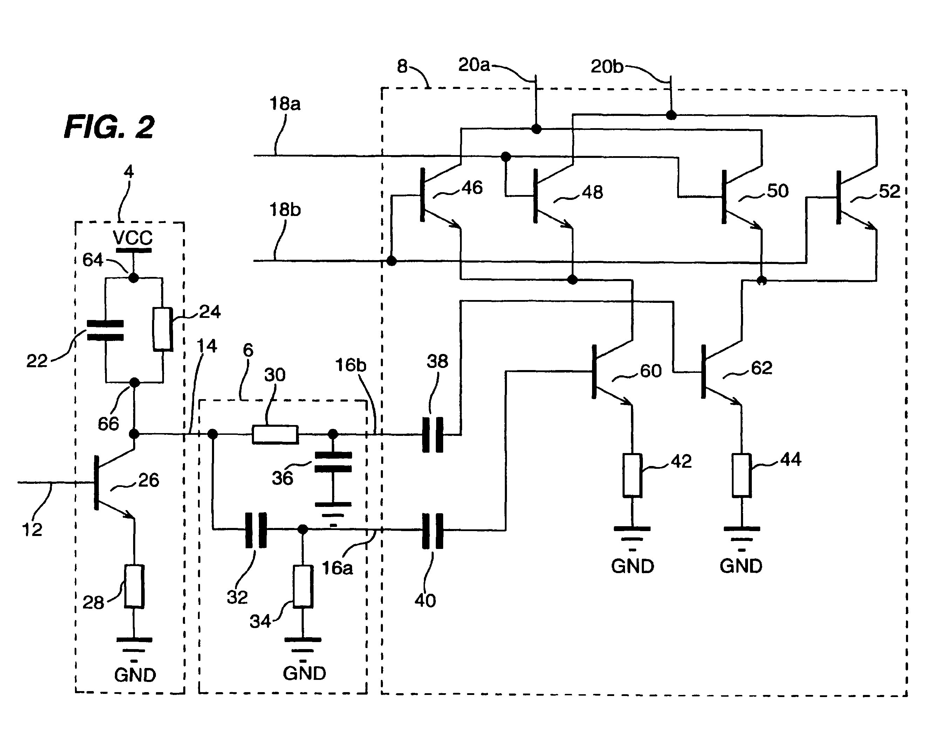

Referring to Figure 2, there is illustrated in more detail the implementation of the matching circuit of Figure 1 and the other elements of the down converter 2.

The amplifier 4 comprises a capacitor 22, an inductor 24, a transistor 26, and an inductor 28. The capacitor 22 and inductor 24 are connected in parallel to form a resonant circuit, having one terminal 64 connected to a supply voltage Vcc, and another terminal 66 connected to the output of the amplifier on line 14. The transistor 26 is, in this preferred embodiment, a bipolar transistor having its base connected to the RF single-ended input signal on line 12, its collector connected to the amplifier output on line 14, and its emitter connected to ground via the inductor 28.

The matching circuit 6 comprises, in this preferred embodiment of the invention, an inductor 30, a capacitor 36, an inductor 34 and a capacitor 32. The inductor 30 has one terminal connected to the input of the matching circuit on line 14 and another terminal connected the second output of the matching circuit on line 16b. The capacitor 36 has one terminal connected to the second output of the matching circuit on line 16b and another terminal connected to ground. The capacitor 32 has one terminal connected to the input of the matching circuit on line 14 and another terminal connected to the first output of the matching circuit on line 16a. The inductor 34 has one terminal connected to the first output of the matching circuit on line 16a and another terminal connected to ground.

The mixer 8 is a double balanced mixer and comprises six transistors 46, 48, 50, 52, 60 and 62, two inductors 42 and 44, and a pair of capacitors 38 and 40. The capacitors 38 and 40 are dc blocking capacitors isolating the dc bias generating circuitry (not shown) from the RF signal, and are not strictly part of the mixer. The first output from the matching circuit 6 on line 16a is connected to the base of the transistor 60 via the dc blocking capacitor 40. The emitter of the transistor 60 is connected to ground via the inductor 42, and the collector of the transistor 60 is connected to the emitters of both transistor 46 and transistor 48. The second output from the matching circuit 6 on line 16b is connected to the base of the transistor 62 via the dc blocking capacitor 38. The emitter of the transistor 62 is connected to ground via the inductor 44, and the collector of the transistor 62 is connected to the emitters of both transistor 50 and transistor 52. The collectors of the transistors 46 and 50 are connected together to form the first output of the mixer 8 on line 20a. The collectors of the transistors 48 and 52 are connected together to form the second output of the mixer on line 20b. The first output from the local oscillator 10 on line 18a is connected to the base of transistor 48 and transistor 50. The second output from the local oscillator 10 on line 18b is connected to the base of transistor 46 and transistor 52.

In the amplifier 4 the transistor 26 along with the resonant circuit formed by the capacitor 22 and the inductor 24 amplify the incoming RF signal on line 12. In practice, a resistor is additionally placed in parallel with the capacitor 22 and inductor 24 to reduce the quality factor of the resonance load.

The inductor 28 of the amplifier 4 performs two tasks. Firstly it controls the linearity/gain of the amplifier formed by the transistor 26 without the extra overhead of extra noise or reduction in dc headroom. Secondly, it could be used as part of the matching network of the transistor 26 to the preceding section which generates the input signal to the amplifier on line 12. For a direct conversion (homodyne) receiver as described herein, the preceding section will typically be a duplexer. For a super-heterodyne receiver, as discussed further hereinafter, the preceding section will typically be a SAW filter.

The matching circuit 6, as discussed above, performs two tasks. Firstly it matches the transistor 26 to the transistors 60 and 62 (i.e. the RF port of the mixer). Secondly, it performs the task of single-ended to balanced conversion, which is normally performed by an external balun.

The blocking capacitors 38 and 40 isolate the RF signal from a dc bias circuit (not shown) for the transistors 60 and 62.

The inductors 42 and 44 of the mixer 8 perform a similar function to the inductor 28 of the amplifier 4. The local oscillator signal on lines 18a and 18b is separated from the RF input signal, in the frequency domain, by the IF frequency. The IF signal is taken from the differential output of the mixer on lines 20a and 20b. Although the mixer output is shown as differential, in certain applications the mixer output may be single ended, even when the inputs to the mixer are differential.

The invention is described hereinabove with reference to the example of driving the RF input of a mixer from a single ended source (a low noise amplifier).

The circuit is most applicable in a fully balanced RF circuit, having better "ambient" noise performance. Such a circuit is suitable for integration with base band function, and hence raises the levels of integration and reduces the overall system cost.

The antenna signal to the radio receiver is in general single ended. It is desirable to convert this signal to a balanced (differential) signal as early as possible in the RF chain. In a homodyne (direct conversion) receiver where an inter-stage image rejection filter is not required between the low noise amplifier and the mixer, this circuit of the invention as described hereinabove can be directly connected to the antenna. That is the signal on line 12 can be provided directly by the antenna. This would make a fully front-end receiver chip, converting the RF signal directly to base band and eliminating the need for bulky and expensive external components, thereby reducing the package size and costs.

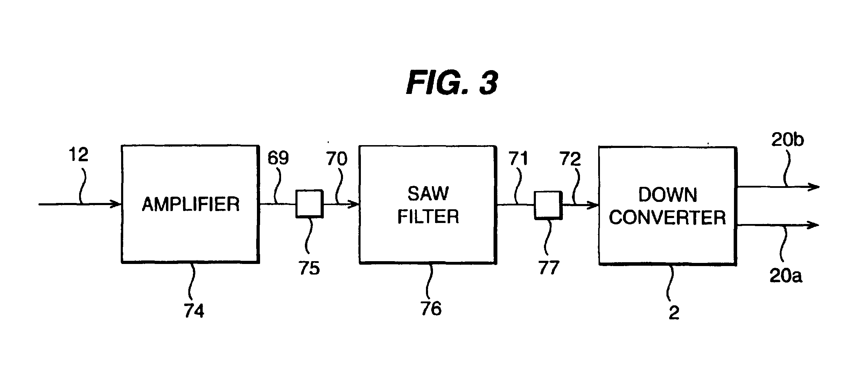

In a super-heterodyne receiver, the circuit of the invention can be used to convert the single ended output of a SAW filter to a balanced one, allowing the mixer to be driven differentially and resulting in better noise and gain performance. An example of this use of the circuit is illustrated in Figure 3.

In Figure 3, there is illustrated a block diagram of a super-heterodyne receiver utilising the down-converter of the present invention. It can be seen that the receiver comprises an amplifier 74, a SAW filter 76, the down-converter 2 of Figure 1 and two matching circuits 75 and 77. The amplifier 74 receives the input RF signal from the front end (antenna) of the receiver on line 12 and generates an amplified received signal on line 69 to the matching circuit 75. The matching circuit 75 matches the amplifier output impedance to the SAW filter input impedance (typically 50 ohms). The output of the matching circuit 75 on line 70 forms an input to the SAW filter, which presents a filtered signal on line 71. The filtered signal on line 71 forms an input to the matching circuit 77. The matching circuit 77 matches the SAW filter output impedance (typically 50 ohms) to the down converter input impedance. The output of the matching circuit 77 on line 72 forms an input to the down-converter 2. The down-converter 2 of the present invention thus operates as a mixer with gain in a super-heterodyne application, introducing the significant advantage of converting the single-ended output of the SAW filter to a differential signal prior to mixing.

Although throughout the above description the circuitry has been described as being implemented using bipolar technology, it will be appreciated that the idea is equally applicable to CMOS circuits.

## Claims

1. Frequency translation circuitry comprising: an amplifier connected to receive as an input a single-ended signal and for generating a single-ended amplified signal; a matching circuit having an input connected to receive the single-ended amplified signal and for generating a differential signal on first and second outputs; and a mixer connected to receive the differential signal at a first differential input port and a further differential signal at a second input port, and for generating a signal at a translated frequency at an output port.

2. Frequency translation circuitry according to claim 2, wherein the matching circuit comprises a first inductor between the input and the first output, a first capacitor between the first output and ground, a second capacitor between the input and the second output and an inductor between the second output and ground.

3. Frequency translation circuitry according to claim 1 or claim 2, wherein the single-ended signal is an RF signal and the further differential signal is a reference signal from a local oscillator, the translated frequency at the output port being a down-converted frequency.

4. Frequency translation circuitry according to claim 3 in a direct conversion receiver, wherein the input single ended RF signal is provided directly from the front-end of the receiver.

5. Frequency translation circuitry according to claim 3 in a super heterodyne receiver, further comprising an amplifier connected to receive an RF signal from the front end of the receiver, a SAW filter connected to receive the amplified front end signal and for generating a filtered RF signal, wherein the filtered RF signal provides the RF input signal.

6. A method of translating a frequency comprising: amplifying a single-ended signal to thereby generate a single-ended amplified signal; converting the single-ended amplified signal to first and second differential signals; and multiplying the first and second differential signals by respective further first and second differential signals, thereby generating a differential signal at a translated frequency.

7. The method of claim 6, wherein the conversion step is performed by circuitry comprising: a first inductor between an input and a first output, a first capacitor between the first output and ground, a second capacitor between the input and a second output and an inductor between the second output and ground, wherein the input is connected to receive the single-ended amplified RF signal, and the first and second differential signals are generated on the first and second outputs.

8. The method of claim 1 or claim 2 wherein the single-ended signal is an RF signal and the further first and second differential signals constitute a reference signal from a local oscillator, the translated frequency at the output port being a down-converted frequency.
